# EUROPEAN PATENT SPECIFICATION

(11) **EP 0 280 273 B1**
(45) Date of publication and mention of the grant of the patent: **21.12.1994**
(21) Application number: 88102723.9
(22) Date of filing: 24.02.1988
(51) Int. Cl.: H01L 39/24, H01L 21/306

(54) **Manufacturing method of conductive or superconductive thin film**
Verfahren zur Herstellung einer leitenden oder supraleitenden dünnen Schicht
Procédé de fabrication d'une couche mince conductrice ou supraconductrice

(30) Priority: 24.02.1987 JP 39182/87
(43) Date of publication of application: 31.08.1988
(73) Proprietor: KAWATETSU MINING COMPANY, LTD., Tokyo 105 (JP); Koinuma, Hideomi, Suginami-Ku Tokyo (JP)
(72) Inventor: Koinuma, Hideomi, Tokyo (JP); Fueki, Kazuo, Tokyo (JP); Kawasaki, Masashi, Tokyo (JP); Nagata, Shunroh, Tokyo (JP)
(74) Representative: Reinhard - Skuhra - Weise & Partner

(56) References cited:
- EP-A- 0 277 885
- FR-A- 2 469 005
- PATENT ABSTRACTS OF JAPAN, vol. 6, no. 95 (E-110)(973), June 3, 1982; & JP-A-57 27079
- ZEITSCHRIFT FÜR PHYSIK B, Condensed Matter 64, 1986, pages189-193; J.G. BEDNORZ et al.: "Possible Hogh Tc Superconductivity in the Ba-La-Cu-O System"

## Description

### Field of the Invention:

The present invention relates to a method for manufacturing a conductive or superconductive thin film, which is expected to be applied to Josephson element or optical sensor etc.

### Description of the prior art:

A conductive material is expected to be applied to a varistor or a sensor etc.

On the other hand, a superconductive material having the properties of no electric resistance, Jesphson effect, perfect diamagnetic property etc. is expected to be used as a coil type conducting wire with no electric loss, a Josephson element or a magnetic shielding material.

A method for manufacturing a conductive or superconductive thin film according to the preamble of claim 1 or 2 is known from EP-A-0 277885. (Prior art according to Art. 54(4) EPC). According to this document the thin film is heat-treated after sputtering has taken place.

Patent abstracts of Japan, volume 6, No. 95 (E-110) (973, June 3, 1992) refers to the manufacturing of a Josephson element of oxide superconductor whereat a target of an oxide superconductive material is sputtered to form a superconductive thin film and heat treatment is performed after sputtering has taken place.

Heretofore, Nb-Sn alloy (critical temperature of the superconductivity: T_{c}=18K), Nb-Ge alloy (T_{c}=23K) or the like has been known as superconductive material.

Recently, a mixed oxide, essentially consisting of lanthanum, alkali-earth metal and copper, practically of La-Sr-Cu-O, La-BaCu-O or La-Ca-Cu-O systems has been found to show the superconductivity at higher temperature (in the case of the mixed oxide containing Sr or Ba as the alkali-earth metal, the T_{c} is 30K or higher) than that of the superconductive material already known, and such mixed oxide material has attracted the attention of many researchers as a superconductive material which may be used under the cooling with liquefied hydrogen (boiling point: 20.3K) or liquefied neon (boiling point: 27.1K).

Furthermore, mixed oxide mainly consisting of lanthanoid metals, barium and copper, practically of Yb-Ba-Cu-O, Er-Ba-Cu-O, Ho-Ba-Cu-O, Tm-Ba-Cu-O systems or those blended was found to be of superconductivity at higher temperature (80K or higher) than that of liquefied nitrogen (boiling point: 77.3K), by which mixed oxide has been drawn more attention abruptly.

However, such mixed oxide consists of a kind of ceramics and has been obliged to get as a sinter heat-treated at 800°C or higher temperature after compression molding of powder-like raw materials, by which such superconductive materials have been kept away from above-mentioned practical uses.

The present invention provides a method for manufacturing a conducting or superconductive thin film of mixed oxide providng an easier way of the application of the mixed oxide type superconductive materials to an electronic material etc. The method according to the present invention is characterized by the features in the characterizing portion of claim 1 or 2.

### Brief Description of the drawings

Figure 1 is to illustrate an exemplary sputtering apparatus to practice the sputtering step of the present invention.

Figure 2 is to illustrate the measured value of the resistivity of the thin film of Example 1 at low temperature, where the ordinate shows the resistivity (10⁻³S⁻¹cm) and the abscissa shows absolute temperature (K).

Figure 3 is to illustrate an exemplary sputtering apparatus equipped with an illuminant of ultraviolet light or vacuum ultraviolet light to carry out the present invention.

Figure 4 is to illustrate the measured value of the resistivity of the thin film of Example 11, using the sputtering apparatus shown in Figure 3, where the ordinate shows the resistivity (10⁻³S⁻¹cm) and the abscissa shows absolute temperature (K).

### Detailed description of the preferred embodiments

The method for manufacturing a conducting or superconductive thin film according to the present invention comprises the step of using a mixed oxide composition showing conductivity or superconductivity as a target material and sputtering it on a substrate to form a thin film.

Further, when the thin film formed is irradiated with ultraviolet light or vacuum ultraviolet light, the conductivity or the superconductivity of the thin film is improved.

Furthermore, when the sputtering of the target material on the substrate is carried out under the radiation of ultraviolet light or vacuum ultraviolet light, the conductive or superconductive thin film can be formed at a lower temperature than the case without the radiation.

That is, the ultraviolet light or vacuum ultraviolet light with the wave length in the range of 110-400 nm excites the oxygen atoms in the atmosphere to ozone or oxygen radical which reacts with the particulate mixed oxide in the gas phase and on the surface of the substrate to increase the oxygen atom combined to the conductive or superconductive thin film.

The example of the mixed oxide composition showing conductivity or superconductivity and to be used as the target material in the present invention is a mixed oxide consisting of lanthanoid, alkali earth metal and copper as main components, particularly, a mixed oxide essentially consisting of La-Sr-Cu-O, La-Ba-Cu-O, La-Ca-Cu-O etc. or those blended materials, furthermore the materials containing small quantity of other metal oxide, or a mixed oxide mainly consisting of Yb-Ba-Cu-O, Er-Ba-Cu-O, Ho-Ba-Cu-O, Tm-Ba-Cu-O or those blended materials.

In the case of aforementioned mixed oxide mainly consisting of lanthanoid, alkali-earth metal and copper,
a composition having a general formula of (La₁₋ₓMₓ)₂CuO_{4-delta} (Here, M represents Ca, Sr or Ba, x represents 0.04-0.20,
preferably 0.05-0.15, and 4-delta represents the atomic value of O atom balancing the atomic value of the metallic components) and with K₂NiF₄ type crystal structure, or
a composition having a general formula of M′₁₋ₓBaₓCu_{y}O_{3-delta} (Here, M′ represents Yb, Er, Ho, Tm or a mixture of lanthanoids, x represents 0.9-0.5, preferably 0.8-0.6, y represents 0.8-1.2, preferably 1.0, and 3-delta represents the atomic value of 0 atom balancing the atomic value of the metallic components) and with oxygen deficient pelovskite type structure, has been known to show high critical temperature Tc (the temperature at which transition to the superconductivity starts), and preferably be used as the target material.

Naturally, another mixed oxide composition other than aforementioned composition which shows the conductivity or superconductivity can be used as the target material in the present invention.

As the target material of the present invention, either a mixed oxide with the composition and the crystal structure showing conductivity or superconductivity itself or a mixed oxide with the same composition, but not yet showing conductivity or superconductivity may be used. From either of which, a conductive or superconductive thin film may be formed by sputtering it on a substrate and simultaneous or subsequent heat treating.

The mixed oxide composition can be used as the target material in a form of a powder or a sinter.

As to the preparation of a sintered mixed oxide to be used as the target in the present invention, blending method of powders of oxide or carbonate of respective components, coprecipitation method, spray-drying method etc. or already known other synthetic method for a powder of mixed oxide may be employed as the first step, whereafter said powder of mixed oxide is calcined, for example, at a temperature above 450°C for 1 hour or more, preferably at a temperature above 800°C for 10 hours or more, then compressed to pellets with an appropriate size, and is sintered at still higher temperature. Alternatively, said powder of mixed oxide may be placed on an appropriately shaped electrode to be used as the target.

Electric source for the sputtering in the present invention can be selected among high frequency current, alternating current or direct current.

Atmospheric gas at the sputtering may be selected among oxygen, ozone, argon, other inert gas, a mixed gas of oxygen and inert gas or a mixed gas of ozone and inert gas.

As the source of ultraviolet light or vacuum ultraviolet light to be used for the excitation of the oxygen atom, any illuminant which radiates ultraviolet light or vacuum ultraviolet light, for example, a deuterium lamp, a mercury lamp, or an excimer laser can be employed.

As a window to introduce the ultraviolet light or vacuum ultraviolet light into the reaction tube of the sputtering apparatus, quartz or a transparent and heat-resistant ceramics such as magnesium fluoride or calcium fluoride may be employed.

Heat-treating of the thin film obtained by sputtering is performed to accelerate the crystallization of the mixed oxide composing the thin film. It is performed at 400-1200°C, preferably at 500-1000°C, because the crystallization would be slow at a temperature under 400°C, and the decomposition of the thin film would occur at a temperature above 1200°C.

Optimum heat treating time depends upon the treating temperature, but it may be taken longer time.

The heat-treating of the thin film may be performed simultaneously with the formation of the thin film through sputtering in a high temperature atmosphere, or may be performed after the formation of the thin film.

The substrate is selected among ceramic or metallic one which withstand the heat-treating temperature.

Sputtering apparatus may be taken from commercial market.

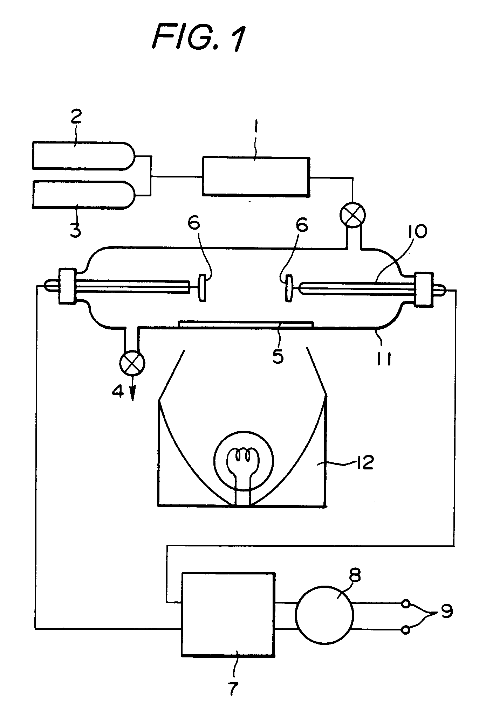

In below-written examples 1-10 describing the manufacturing of a superconducting thin film, without the ultraviolet irradiating step, was used an apparatus shown in Figure 1, wherein mark 1 is a flow meter, 2 is an argon cylinder, 3 is an oxygen cylinder, 4 is a rotary pump and a diffusion pump, 5 is a substrate, 6 is a target, 7 is a neon sign transformer, 8 is a variable voltage regulator, 9 is alternative current 100V electric source, 10 is a electrode bar, 11 is a reaction tube and 12 is a infrared lamp to heat the substrate(5).

### EXAMPLE 1

Using the sputtering apparatus as shown in Figure 1, equipped with targets composed of a mixed oxide with the formula of (La_{0.9}Sr_{0.1})₂CuO_{4-delta}, sputtering on a zirconium oxide substrate was carried out under the condition of reaction pressure of 6.7 Pa (50 mTorr), alternative current (50Hz) of 5400V, in the atmosphere of Argon containing 5% oxygen, to obtain a thin film of said mixed oxide with a thickness of 1 micrometer. Then thus obtained film was heat treated in an electric furnace at 550°C for 10 hours.

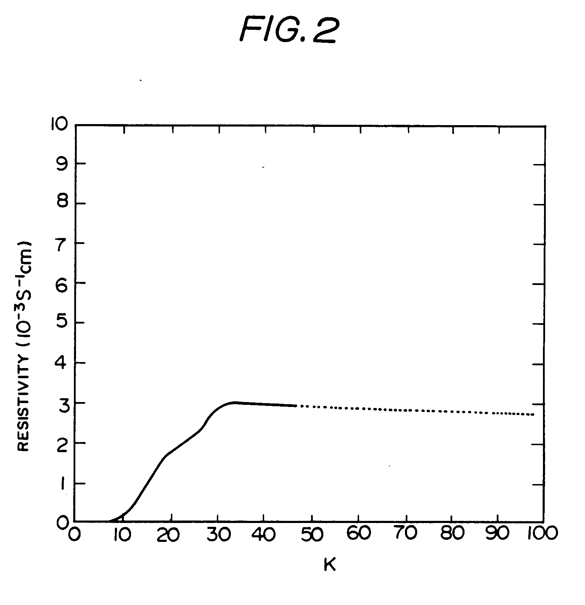

The electric resistance of the thin film at low temperature was measured and found that the transition to the superconductive state was started at a temperature of about 32K as shown in Figure 2, becoming in the superconductive state below the limit of measurement at a temperature of about 10K.

### EXAMPLE 2

Using targets composing of a mixed oxide with the formula of (La_{0.9}Sr_{0.1})₂CuO_{4-delta}, sputtering on a "Corning 7059" substrate was carried out in the same manner as EXAMPLE 1 to obtain a thin film of said mixed oxide with a thickness of 1 micrometer and the thin film was heat-treated in the same manner as EXAMPLE 1.

Thus produced thin film started the transition to the superconductive state at a temperature of about 30K.

### EXAMPLE 3

Using targets composing of a mixed oxide with the formula of (La_{0.9}Ca_{0.1})₂CuO_{4-delta}, sputtering on a sapphire substrate was carried out in the same manner as EXAMPLE 1 and a thin film of said mixed oxide with a thickness of 1 micrometer was obtained and the thin film was heat-treated in the same manner as EXAMPLE 1.

Thus produced film started the transition to superconductive state at a temperature of about 15K.

### EXAMPLE 4

Using targets composing of a mixed oxide with the formula of (La_{0.9}Sr_{0.05}Ba_{0.05})₂CuO_{4-delta}, sputtering on a magnesium oxide substrate was carried out in the same manner in EXAMPLE 1 to obtain a thin film of said mixed oxide with a thickness of 1 micrometer and the thin film was heat-treated in the same manner as EXAMPLE 1.

Thus produced thin film started the transition to the superconductive state at a temperature of about 31K.

### EXAMPLE 5

Using targets composing of a mixed oxide with the formula of (La_{0.85}Sr_{0.15})₂CuO_{4-delta}, sputtering on a "Corning 7059" substrate was carried out in the same manner as EXAMPLE 1 to obtain a thin film of said mixed oxide with a thickness of 1 micrometer.

Thus produced thin film showed a high conductivity of about 300 S·cm⁻¹, by measuring it at room temperature.

### EXAMPLE 6

Using the sputtering apparatus as shown in Figure 1, equipped with targets composing of a mixed oxide with the formula of Yb_{0.3}Ba_{0.7}CuO_{3-delta}, sputtering on a zirconium oxide substrate was carried out under the condition of reaction pressure of 1 mTorr, alternative current (50Hz) of 9000V, in an atmosphere of Argon containing 10% oxygen, and a thin film of said mixed oxide with a thickness of 1 micrometer was obtained.

The electric resistance of the thin film at low temperature was measured and was found that the transition to the superconductive state started at a temperature of about 90K becoming in the superconductive state below the limit of measurement at a temperature of about 65K.

### EXAMPLE 7

Using targets composing of a mixed oxide with the formula of Er_{0.25}Ba_{0.75}CuO_{3-delta}, sputtering on a "Corning 7059" substrate was carried out in the same manner as EXAMPLE 6 and a thin film of said mixed oxide with a thickness of 1 micrometer was obtained. Then thus obtained film was heat treated in an electric furnace at 550°C for 2 hours.

Thus produced thin film started the transition to the superconductive state at a temperature of about 90K.

### EXAMPLE 8

Using targets composing of a mixed oxide with the formula of Tm_{0.3}Ba_{0.7}CuO_{3-delta}, sputtering on a sapphire substrate was carried out in the same manner as EXAMPLE 6 and a thin film of said mixed oxide with a thickness of 1 micrometer was obtained and the thin film was heat-treated in the same manner as EXAMPLE 7.

Thus produced film started the transition to superconductive state at a temperature of about 95°K.

### EXAMPLE 9

Using targets composing of a mixed oxide with the formula of M_{0.3}Ba_{0.7}CuO_{3-delta} wherein M is a mixture of lanthanoids, sputtering on a "Corning 7059" substrate was carried out in the same manner as EXAMPLE 6 and a thin film of said mixed oxide with a thickness of 1 micrometer was obtained. Then thus obtained film was heat treated in an electric furnace in the same manner as EXAMPLE 7.

Thus produced thin film started the transition to the superconductive state at a temperature of about 93K.

### EXAMPLE 10

Using targets composing of a mixed oxide with the formula of Yb_{0.25}Ba_{0.75}CuO_{3-delta}, sputtering on a "Corning 7059" substrate was carried out in the same manner as EXAMPLE 6 and a thin film of said mixed oxide with a thickness of 1 micrometer was obtained.

Thus produced thin film showed a high conductivity of about 500S·cm⁻¹, by measuring it at room temperature.

### EXAMPLE 11

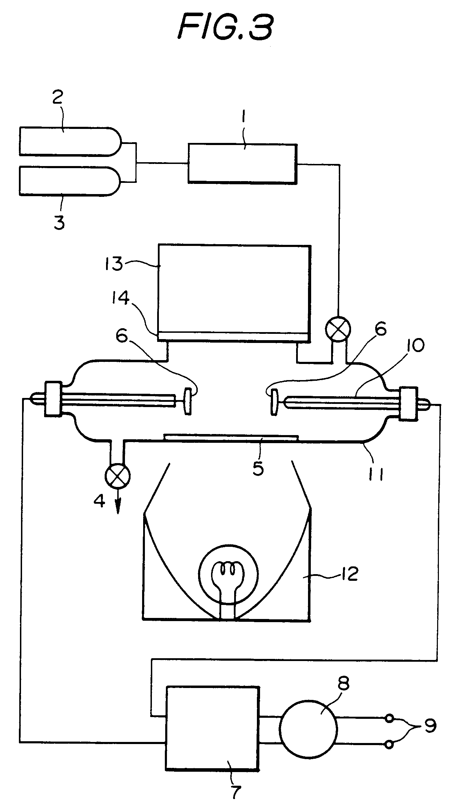

Using the sputtering apparatus as shown in Figure 3, wherein mark 13 is an illuminant of ultraviolet light or vacuum ultraviolet light, and mark 14 is a window to permeate the said light, and equipped with targets composing of a mixed oxide with the formula of Yb_{1.0}Ba_{2.0}Cu_{3.6}Oₓ (x=6-8) sputtering on a strontium titanate substrate was carried out under the condition of reaction pressure of 13.3 Pa (100 mTorr), temperature of 500°C, alternative current (50Hz) of 9000V, in an atmosphere of Argon containing 50% oxygen, under the radiation of ultraviolet light and a thin film of said mixed oxide with a thickness of 1 micron was obtained after 2 hours.

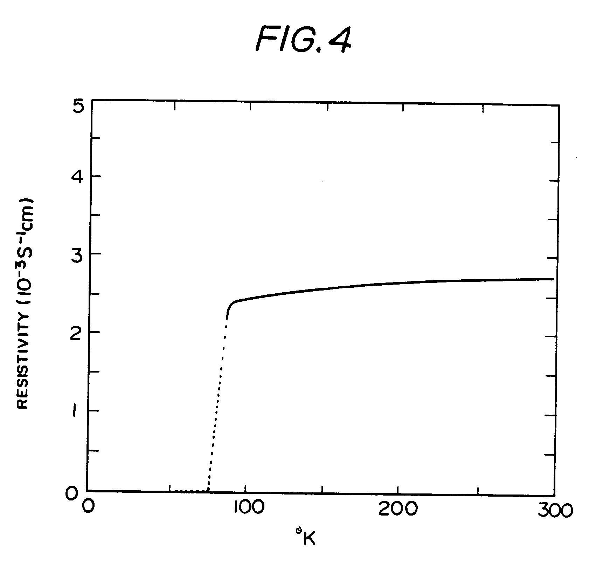

The electric resistance of the thin film at low temperature was measured and found that the transition to the superconductive state started at a temperature of about 80°K as shown in Figure 4, becoming in the superconductive state below the limit of measurement at a temperature of about 65°K.

When an ultraviolet light with the wave length in a range of 110-400 nm was irradiated on the thin film, the conductivity and superconductivity of the thin film was improved. It is thought that the ultraviolet light excited the oxygen atoms in the atmosphere to ozone or oxygen radical, and these excited ozone or oxygen radical promoted the intake of the oxygen in the thin film.

## Claims

1. A method for manufacturing a conductive or superconductive thin film which comprises using a mixed oxide composition showing conductivity or superconductivity as a target material, and sputtering the target material onto a substrate to form a thin film, characterized by irradiating the thin film with ultraviolet light or vacuum ultraviolet light in an oxygen atmosphere after forming.

2. A method for manufacturing a conductive or superconductive thin film which comprises using a mixed oxide composition showing conductivity or superconductivity as a target material, and sputtering the mixed oxide composition onto a substrate to form a thin film, characterized by carrying out the sputtering of the target material under radiation of ultraviolet light or vacuum ultraviolet light.

3. A method as claimed in claim 1 or 2, wherein the mixed oxide composition showing conductivity or superconductivity comprises lanthanoid, alkali earth metal and copper as main components.

4. A method according to claim 1, 2 or 3, wherein the thin film is heat-treated after forming.

## Patentansprüche

1. Verfahren zur Herstellung einer leitenden oder supraleitenden dünnen Schicht, wobei das Verfahren die Verwendung einer Mischoxid-Zusammensetzung mit einer Leitfähigkeit oder Supraleitfähigkeit als ein Targetmaterial und das Zerstäuben des Targetmaterials auf ein Substrat umfaßt, um eine dünne Schicht zu bilden,
**gekennzeichnet durch**
Bestrahlung der dünnen Schicht mit Ultraviolettlicht oder Vakuum-Ultraviolettlicht in einer Sauerstoffatmosphäre nach der Ausbildung.

2. Verfahren zur Herstellung einer leitenden oder supraleitenden dünnen Schicht, wobei das Verfahren die Verwendung einer Mischoxid-Zusammensetzung mit einer Leitfähigkeit oder einer Supraleitfähigkeit als ein Targetmaterial und das Zerstäuben der Mischoxid-Zusammensetzung auf ein Substrat umfaßt, um eine dünne Schicht zu bilden, gekennzeichnet durch
die Zerstäubung des Targetmaterials unter Bestrahlung mit Ultraviolettlicht oder Vakuum-Ultraviolettlicht.

3. Verfahren nach Anspruch 1 oder 2, worin die eine Leitfähigkeit oder Supraleitfähigkeit aufweisende Mischoxid-Zusammensetzung ein Lanthanoid, ein Erdalkalimetall und Kupfer als Hauptbestandteile aufweist.

4. Verfahren nach Anspruch 1, 2 oder 3, worin die dünne Schicht nach der Ausbildung hitzebehandelt wird.

## Revendications

1. Procédé de préparation d'un film mince conducteur ou supraconducteur, qui consiste à utiliser, en tant que matière-cible, une composition d'oxyde mixte manifestant de la conductivité ou de la supraconductivité et à projeter la matière-cible sur un substrat de façon à former un film mince, caractérisé par une irradiation du film mince au moyen de lumière dans l'ultraviolet ou de lumière dans l'ultraviolet lointain, dans une atmosphère d'oxygène, après formage.

2. Procédé de préparation d'un film mince conducteur ou supraconducteur, qui consiste à utiliser, en tant que matière-cible, une composition d'oxyde mixte manifestant de la conductivité ou de la supraconductivité et à projeter la composition d'oxyde mixte sur un substrat de façon à former un film mince, caractérisé par l'exécution de la projection de la matière-cible par pulvérisation cathodique sous un rayonnement de lumière dans l'ultraviolet ou de lumière dans l'ultraviolet lointain.

3. Procédé selon l'une des revendications 1 et 2, selon lequel la composition d'oxyde mixte manifestant de la conductivité ou de la supraconductivité comprend un lanthanide, un métal alcalinoterreux et du cuivre en tant que composants principaux.

4. Procédé selon l'une des revendications 1, 2 et 3, selon lequel on soumet le film mince à un traitement thermique après formage.
